Europäisches Patentamt

European Patent Office

Office européen des brevets

(11) Numéro de publication : **0 088 663**
**B1**

(12) **FASCICULE DE BREVET EUROPÉEN**

(45) Date de publication du fascicule du brevet :
30.12.86

(21) Numéro de dépôt : **83400363.4**

(22) Date de dépôt : **22.02.83**

(51) Int. Cl.⁴ : **H 01 J   3/22**, H 01 J 29/66,
H 01 J 37/141,
H 01 J 23/087,
H 01 J   9/236

(54) Solénoide de focalisation, application et procédé de fabrication de ce solénoide.

(30) Priorité : **05.03.82 FR 8203731**

(43) Date de publication de la demande :
**14.09.83 Bulletin 83/37**

(45) Mention de la délivrance du brevet :
**30.12.86 Bulletin 86/52**

(84) Etats contractants désignés :
**DE GB NL**

(56) Documents cités :
**EP-A- 0 019 328**
**FR-A- 2 181 464**
**US-A- 2 706 366**
**US-A- 2 763 805**
**PATENTS   ABSTRACTS   OF   JAPAN,   vol.   2,   no**
**154(E78), 25 décembre 1978, Tokyo, JP.**

(73) Titulaire : **THOMSON-CSF**
**173, Boulevard Haussmann**
**F-75379 Paris Cedex 08 (FR)**

(72) Inventeur : **Caillat, Pierre**
**THOMSON-CSF SCPI 173, bld Haussmann**
**F-75379 Paris Cedex 08 (FR)**

(74) Mandataire : **Mayeux, Michèle et al**
**THOMSON-CSF SCPI 19, avenue de Messine**
**F-75008 Paris (FR)**

EP 0 088 663 B1

## Description

La présente invention concerne un solénoïde de focalisation. Elle concerne également l'application et un procédé de fabrication de ce solénoïde.

La présente invention se rapporte au domaine de la focalisation d'un faisceau d'électrons dans un tube électronique. Dans un tube électronique, il est connu de prévoir un dispositif de focalisation ayant pour fonction de s'opposer à la divergence naturelle des électrons du faisceau. Ce dispositif crée souvent un champ magnétique dirigé selon l'axe du tube et provoquant la rotation des électrons divergents autour de ses lignes de force. Dans certaines applications, les exigences de concentration du faisceau sont particulièrement rigoureuses. C'est le cas, par exemple, des tubes électroniques destinés à la prise de vue, des microscopes électroniques et des tubes électroniques hyperfréquences.

Dans les tubes de prise de vue, il est connu d'utiliser pour focaliser le faisceau un solénoïde, disposé autour du tube, et constitué par un fil métallique isolé, en cuivre émaillé par exemple, qui est enroulé en forme d'hélice autour d'un manchon isolant, en verre époxy par exemple. Les spires de l'hélice sont jointives et le solénoïde comporte plusieurs couches de fil superposées, ayant un même sens d'enroulement autour du manchon.

Ainsi par exemple, sur un manchon de 3 cm de diamètre et de 8 cm de long, on superpose 20 couches de 300 spires chacune en utilisant un fil de 25/100e de mm de diamètre.

Le fil est bobiné sur le manchon en utilisant un tour comportant un guide-fil et l'arrangement des spires est contrôlé à la main. Après avoir bobiné une couche, on bobine par-dessus la couche suivante, sans couper le fil, mais en inversant l'inclinaison des spires sur l'axe. Ainsi, le sens d'enroulement du fil autour du manchon est toujours le même et le courant circule toujours dans le même sens ce qui permet d'obtenir, en première approximation, un champ magnétique uniforme parallèle à l'axe. Deux flasques fixées aux extrémités du manchon maintiennent les couches de fil en place.

Le problème qui se pose est que les spires des différentes couches ne sont pas régulièrement réparties ce qui fait que le type de solénoïde de focalisation qui vient d'être décrit donne de mauvaises caractéristiques au tube de prise de vue auquel il est associé.

Ainsi, ce solénoïde provoque une déflexion parasite de l'image qui se traduit par un « décadrage ». Il provoque aussi une erreur d'orthogonalité. Le retour rapide du faisceau commandé par les bobines de déflexion constitue un parasite qui est transmis sur la cible par le solénoïde de focalisation ce qui perturbe le signal vidéo. Enfin, on observe que le taux de modulation varie d'un solénoïde à l'autre, et on observe aussi un manque d'homogénéité de résolution du tube.

Un autre type de solénoïde est proposé dans la demande de brevet français FR-A-2 181 464. Il y est décrit, entre autres, des enroulements réalisés sur des manchons présentant une forme sensiblement cylindrique ; ces manchons comportent sur leur paroi externe : un méplat longitudinal sur un angle dièdre d'environ 90° et des encoches circulaires qui s'arrêtent de part et d'autre du méplat et dont les plans médians sont sensiblement perpendiculaires à l'axe longitudinal du manchon. Le méplat constitue une face de croisement pour choisir la façon de ranger les spires, et les encoches servent à guider les spires ; mais d'une part, en raison du méplat et du type d'encoches utilisés, le champ à l'intérieur du bobinage n'a pas l'homogénéité du champ à l'intérieur d'un bobinage en hélice régulière, et d'autre part un bobinage parfaitement régulier est difficile à obtenir surtout lorsque plusieurs couches doivent être bobinées sur le même manchon.

La présente invention concerne un nouveau solénoïde de focalisation qui supprime les défauts dus aux solénoïdes de focalisation connus en assurant une répartition régulière des spires. Ce nouveau solénoïde présente aussi l'intérêt d'être de fabrication plus facile.

La présente invention, définie par les revendications annexées, concerne un solénoïde de focalisation dont le manchon, autour duquel le fil est enroulé, est cylindrique et porte une gravure hélicoïdale dans laquelle sont logées les spires de la première couche de fil.

D'autres objets, caractéristiques et résultats de l'invention ressortiront de la description suivante donnée à titre d'exemple non limitatif et illustrée par les figures annexées qui représentent :

la figure 1   un schéma illustrant la constitution d'un solénoïde de focalisation selon l'art antérieur ;

les figures 2 et 3   des schémas illustrant la constitution d'un solénoïde de focalisation selon l'invention ;

les figures 4a et b   des vues en coupe illustrant le positionnement des différentes couches de fil, respectivement, dans un solénoïde selon l'invention et dans un solénoïde selon l'art antérieur ;

les figures 5 et 9   deux vues en coupe longitudinale de deux modes de réalisation d'un solénoïde selon l'invention ;

les figures 6 et 10   deux schémas montrant comment sont réalisées les connexions entre les couches pour les modes de réalisation des figures 5 et 9 ;

la figure 7   deux schémas illustrant le procédé de fabrication d'un solénoïde selon l'invention ;

la figure 8   une vue en coupe d'un manchon démontable.

Sur les différentes figures, les mêmes repères désignent les mêmes éléments, mais, pour des raisons de clarté, les cotes et proportions des divers éléments ne sont pas respectées.

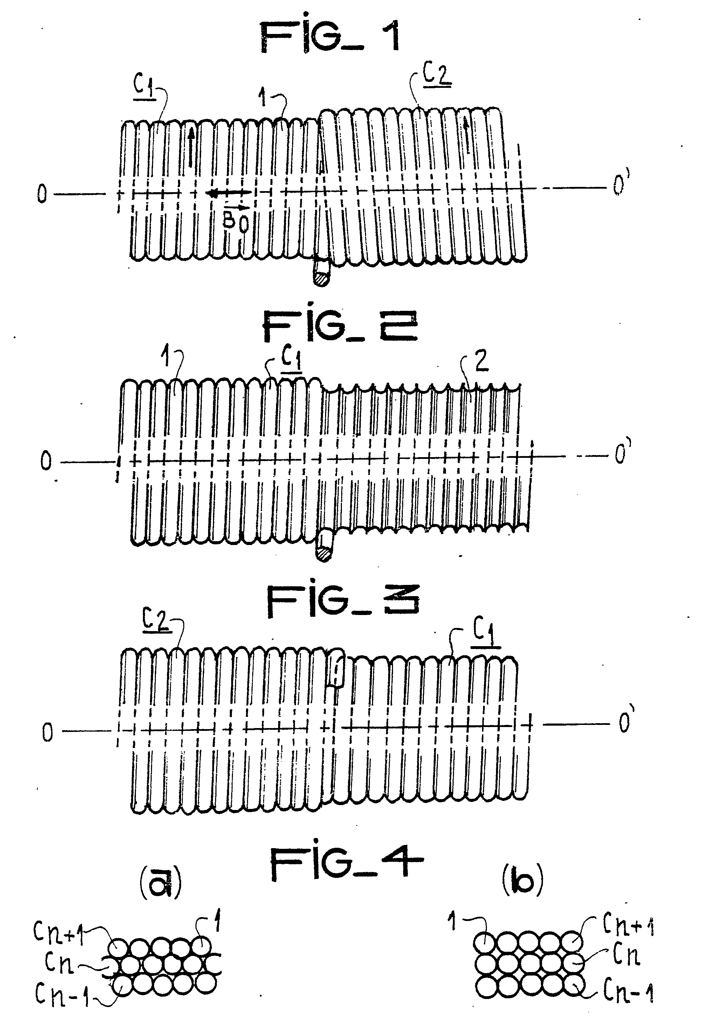

La figure 1 illustre, de façon schématique, la constitution d'un solénoïde de focalisation selon l'art antérieur.

Ce solénoïde est obtenu en enroulant un fil métallique isolé 1 sur un manchon cylindrique isolant qui n'est pas représenté sur la figure.

Le fil est enroulé en forme d'hélice autour du manchon et les spires de l'hélice sont jointives comme cela a été représenté sur la figure. Après avoir bobiné la première couche $C_1$, on bobine par-dessus la deuxième $C_2$, sans couper le fil, mais en inversant l'inclinaison des spires sur l'axe, tout en conservant le même pas pour l'hélice. Sur la figure 1, on voit que pour la couche $C_1$, les spires de l'hélice sont inclinées à droite sur l'axe OO' du manchon, alors que pour la couche $C_2$, les spires de l'hélice sont inclinées à gauche. Ainsi le courant circule toujours dans le même sens dans tout le solénoïde. Sur la figure 1, on a indiqué par une flèche le sens de circulation du courant dans la couche de fil $C_1$. Le courant circule dans cette couche de bas en haut sur la figure, c'est-à-dire dans le sens inverse des aiguilles d'une montre si le solénoïde est vu du côté gauche.

Sur la figure, on a indiqué aussi par une flèche le sens de circulation du courant dans la couche de fil $C_2$ et on constate que le courant circule également dans cette couche dans le sens inverse des aiguilles d'une montre si le solénoïde est vu du côté gauche. Il y a donc création d'un champ magnétique uniforme $\vec{B_o}$ dirigé selon l'axe OO' du tube. Après avoir bobiné la deuxième couche, on bobine la troisième en inclinant les spires à droite et ainsi de suite pour les autres couches, on inverse à chaque fois l'inclinaison des spires sur l'axe.

La figure 2 illustre de façon schématique la constitution d'un solénoïde de focalisation selon l'invention.

Sur la partie droite de la figure 2, on a représenté le manchon isolant 2 qui porte les couches de fil.

Selon l'invention, ce manchon porte une gravure hélicoïdale dans laquelle sont logées les spires de la première couche $C_1$ de fil 1 qui est représentée sur la partie gauche de la figure 2.

Le pas de l'hélice gravée sur le manchon doit être très légèrement supérieur au diamètre du fil pour que les spires de fil soient sensiblement jointives.

Ainsi, par exemple, si l'on utilise un fil en cuivre émaillé de 25/100e de mm de diamètre, on grave sur le manchon une hélice de 26/100e de pas.

La profondeur de la gravure réalisée sur le manchon est de l'ordre de la moitié du diamètre du fil.

Dans l'exemple cité précédemment, la profondeur de la gravure est de 1/10e de mm. La première couche de fil $C_1$ dépasse donc de la gravure de la moitié environ du diamètre de fil.

Sur les figures 1 et 2, on a indiqué par des pointillés que les proportions entre la hauteur des spires de fil (ou la hauteur de la gravure du manchon) et leur largeur ne pouvaient être respectées sur les figures pour des raisons de clarté.

En effet, ce rapport est supérieur à 100.

Ainsi, il faut bien voir que si l'on examine à l'œil nu un fourreau de 3 cm de diamètre portant une gravure hélicoïdale de 26/100e de pas et de 1/10e de profondeur, la surface du manchon paraît presque lisse, et en tout cas beaucoup moins heurtée que ce qui est représenté sur la figure 2.

Cette gravure du manchon est cependant suffisante pour que les spires de la première couche $C_1$ soient bien maintenues en place.

En ce qui concerne la réalisation du solénoïde, elle se fait toujours en utilisant un tour et un guide-fil mais on constate qu'il n'est plus nécessaire de guider le fil à la main que pour les premières spires, car le fil vient ensuite se placer de lui-même dans la gravure du manchon.

La répartition des spires de la première couche sur le manchon est quasiment parfaite et les spires sont donc sensiblement perpendiculaires à l'axe du manchon.

Dans les solénoïdes selon l'art antérieur, le manchon étant lisse, la répartition des spires de la première couche sur le manchon est généralement beaucoup moins régulière et, en tout cas, une répartition régulière des spires est beaucoup plus difficile à réaliser.

La figure 3 montre que dans le solénoïde selon l'invention, pour chaque couche de fil, l'inclinaison des spires de l'hélice par rapport au manchon est la même. Ainsi sur la figure 3, on voit que, pour la couche $C_2$ comme pour la couche $C_1$, les spires de l'hélice sont inclinées à droite sur l'axe OO'. Selon l'invention, la première couche $C_1$ de fil qui dépasse de la gravure du manchon sert de guide à la deuxième couche $C_2$ dont les spires ont même inclinaison que celles de la première. Et ainsi de suite, selon l'invention, chaque couche de fil est utilisée pour positionner la couche de fil suivante. Ainsi, toutes les couches de fil ont des spires bien réparties et sensiblement perpendiculaires à l'axe du manchon et, pour réaliser le solénoïde, à chaque couche, il ne faut guider à la main le fil que pour les première spires.

Au contraire dans les solénoïdes selon l'art antérieur comme les spires d'une couche ont une inclinaison contraire à celle des spires de la couche suivante, il n'y a pas guidage du fil et les spires des différentes couches sont mal réparties et difficiles à bien positionner. On peut d'ailleurs constater en examinant attentivement un solénoïde selon l'art antérieur que sa surface présente des effets de moiré indiquant une mauvaise répartition des spires.

Les figures 4a et b sont des coupes montrant de façon schématique, comment sont positionnées les différentes couches de fil, $C_{n+1}$, $C_n$ et $C_{n-1}$.

Dans le solénoïde selon l'invention, on voit sur la figure 4a que les spires d'une couche sont guidées par les spires de la couche précédente et se logent dans la rainure hélicoïdale due à cette couche précédente. Dans le solénoïde selon l'art antérieur, on voit sur la figure 4b qu'il n'y a pas de guidage des spires d'une couche par celles de la couche précédente puisque l'inclinaison des spires est inversée d'une couche à la suivante. Les spires d'une couche ne se logent pas dans la rainure hélicoïdale due à la couche précédente.

On a vu sur la figure 3 que dans le solénoïde selon l'invention, pour toutes les couches de fil enroulées en hélice autour d'un manchon, l'inclinaison des spires de l'hélice par rapport au manchon est sensiblement la même. Il se pose cependant le problème de la connexion entre les différentes couches de fil pour que toutes les couches du solénoïde aient le même sens d'enroulement autour du manchon.

La figure 5 est une vue en coupe longitudinale selon l'axe OO' montrant de façon schématique un mode de réalisation d'un solénoïde selon l'invention qui résout avantageusement le problème des connexions entre les couches.

Dans le mode de réalisation de la figure 5, le solénoïde selon l'invention comporte un premier manchon 2 tel que celui de la figure 2. Ce manchon 2 porte la moitié des couches du solénoïde. On désigne par $C_d$ l'ensemble des couches portées par ce manchon 2.

On réalise la première couche de fil en logeant les spires de l'hélice dans la gravure hélicoïdale du manchon 2.

Le fil est coupé lorsqu'on arrive à la fin de la première couche.

On bobine par-dessus la première couche une deuxième couche en utilisant la première couche comme guide, comme cela est représenté sur la figure 3.

Le fil est coupé à la fin de la deuxième couche.

On bobine ainsi autour du manchon la moitié des couches, en coupant le fil à la fin de chaque couche, et de façon que l'inclinaison des spires de l'hélice par rapport au manchon soit sensiblement la même pour toutes ces couches.

Autour des couches $C_d$, on introduit un deuxième manchon 3, semblable au premier et présentant la même gravure hélicoïdale mais réalisée en sens contraire.

Autour de ce deuxième manchon, on enroule l'autre moitié des couches du solénoïde que l'on désigne par $C_f$, comme on a enroulé les couches $C_d$ autour du manchon 2. C'est-à-dire que la première couche est logée dans la gravure du manchon, le fil est coupé après chaque couche et pour toutes les couches, l'inclinaison des spires de l'hélice par rapport au manchon est sensiblement la même.

Pour que toutes les couches du solénoïde aient le même sens de parcours autour du manchon, on réalise des connexions entre les extrémités d'une couche réalisée autour d'un manchon et les extrémités, situées du même côté des manchons, de deux autres couches réalisées autour de l'autre manchon.

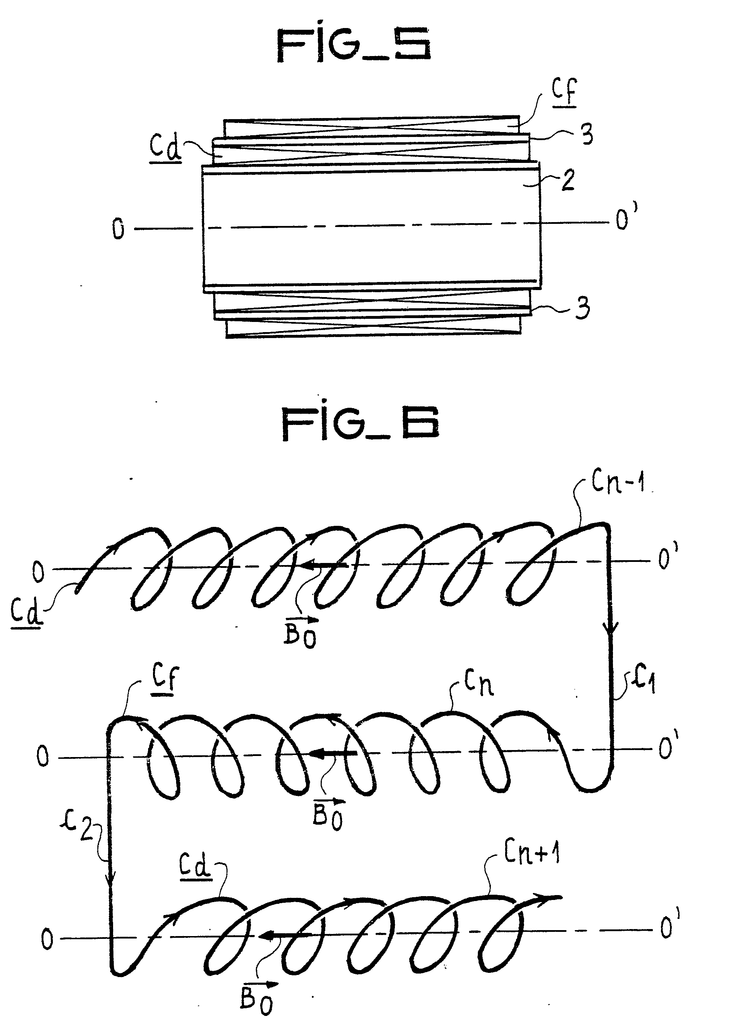

On a représenté sur la figure 6 les connexions qu'il fallait réaliser pour connecter convenablement une couche $C_n$ inclinée sur la gauche, appartenant aux couches $C_f$ bobinées autour du deuxième manchon, à deux couches $C_{n-1}$ et $C_{n+1}$ inclinées sur la droite, appartenant aux couches $C_d$ bobinées autour du premier manchon.

On relie par la connexion $c_1$ l'extrémité de la couche $C_{n-1}$ située à droite des manchons sur la figure à l'extrémité de la couche $C_n$ située à droite des manchons, et on relie par la connexion $c_2$ l'extrémité de la couche $C_n$ située à gauche des manchons à l'extrémité de la couche $C_{n+1}$ située à gauche des manchons.

On constate sur la figure 6 que toutes les couches ont ainsi le même sens de parcours par rapport aux manchons disposés selon l'axe OO'. Le courant circule dans toutes les couches du solénoïde vu de gauche dans le sens inverse des aiguilles d'une montre. Ainsi, est créé un champ magnétique uniforme $\vec{B_0}$ sur l'axe OO'.

Les connexions telles que $c_1$ et $c_2$ entre les extrémités situées du même côté des manchons de deux couches voisines sont réalisées en torsadant ensemble deux courts morceaux de fil qui sont ensuite soudés, en les plongeant dans un bac d'étain en fusion par exemple. Les connexions ainsi réalisées ne peuvent pas produire de parasites gênants.

On connaît des modes de réalisations de l'invention proches de celui qui vient d'être décrit et qui s'en distinguent parce qu'ils comportent plus de deux manchons. Chaque manchon présente alors la même gravure hélicoïdale que celle du précédent, mais de sens contraire.

Dans un mode de réalisation bien particulier de l'invention, chaque manchon ne porte qu'une seule couche logée dans la gravure hélicoïdale du manchon.

Il se pose cependant le problème de l'encombrement supplémentaire dû à la présence des manchons.

On va maintenant décrire un procédé qui permet de supprimer tous les manchons, excepté le premier, tout en conservant les qualités des solénoïdes selon l'invention.

Prenons pour exemple le cas d'un solénoïde utilisant deux manchons.

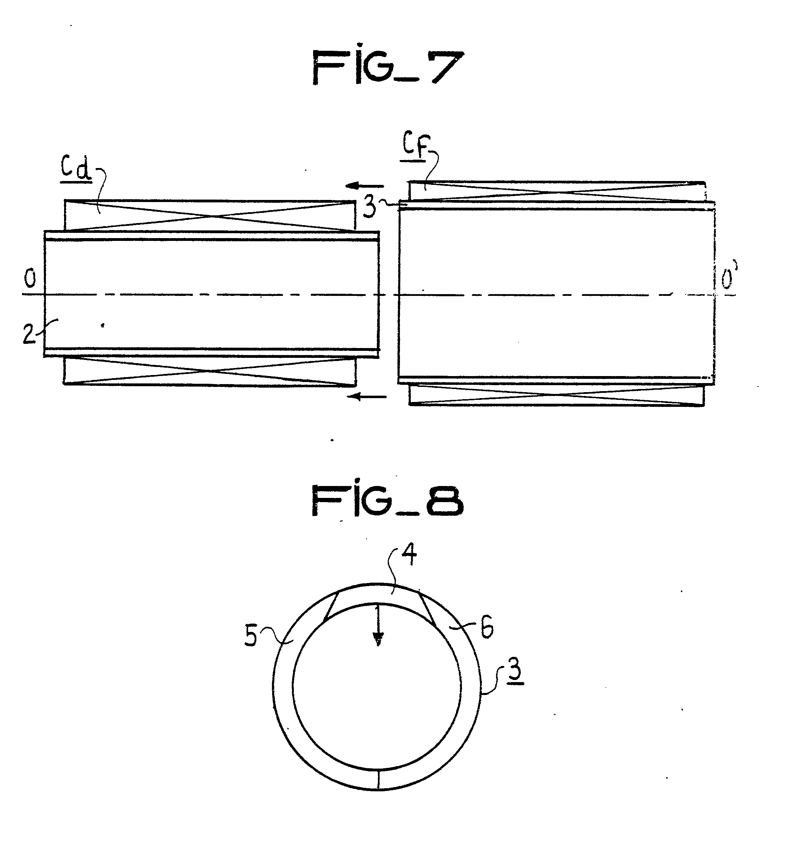

On enroule la première moitié $C_d$ des couches autour du premier manchon 2, en coupant le fil à chaque couche, et en enroulant toutes les couches en conservant la même inclinaison. Cette première étape est représentée sur la partie gauche de la figure 7.

On utilise ensuite un deuxième manchon 3 dont le diamètre externe est égal au diamètre externe du premier manchon recouvert de ses couches de fil. Ce deuxième manchon est gravé en sens inverse au premier et on enroule autour de ce deuxième manchon l'autre moitié des couches $C_f$, comme on l'a fait autour du premier. Cette deuxième étape est représentée sur la partie droite de la figure 7.

Le fil qui est utilisé pour réaliser au moins cette autre moitié de couches $C_f$ a la propriété de devenir adhérent sous l'action de la chaleur.

Après avoir bobiné le fil, on agglomère ces couches $C_f$ entre elles en utilisant un jet d'air chaud ou en faisant passer un courant d'intensité élevée dans le fil.

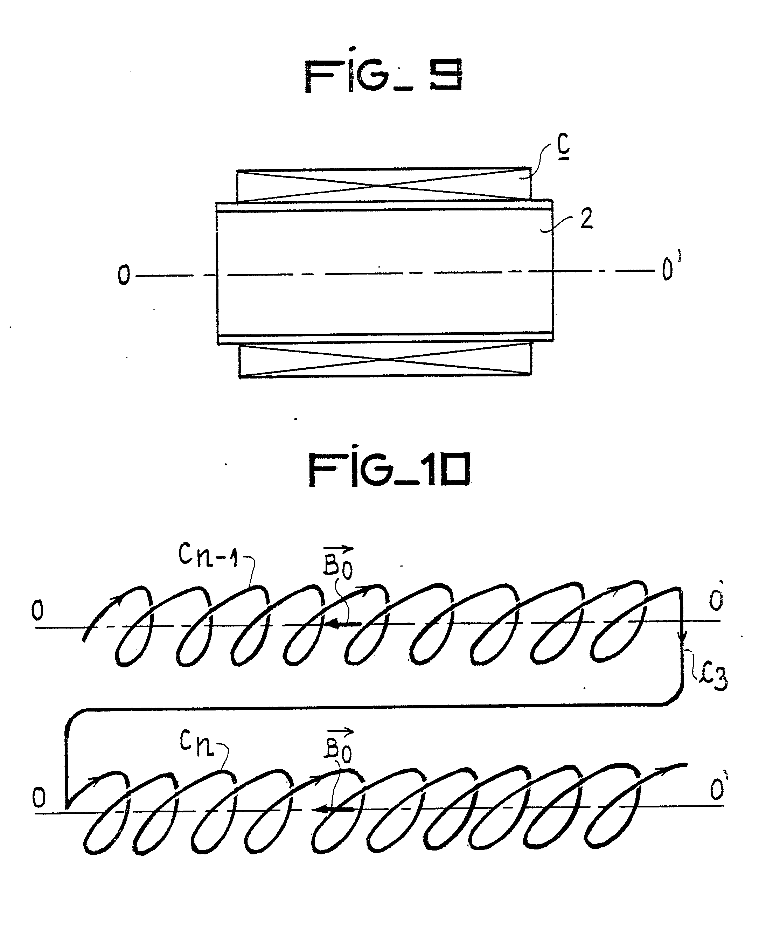

On chasse alors le deuxième manchon. Pour cela, on peut utiliser un manchon démontable en trois parties tel que celui représenté sur la figure 8. Il suffit d'enlever la partie centrale 4 et les parties latérales 5 et 6 sont libérées.

On ajuste alors la deuxième moitié de couches $C_f$ sur la première moitié de couches $C_d$. Il suffit ensuite de réaliser les connexions entre les différentes couches.

Ce procédé peut bien entendu être utilisé lorsqu'on utilise plus de deux manchons.

Sur la figure 9, on a représenté un autre mode de réalisation du solénoïde selon l'invention qui n'utilise qu'un seul manchon.

Dans ce mode de réalisation de l'invention, pour toutes les couches de fil C enroulées en hélice autour du manchon 2, l'inclinaison des spires de l'hélice par rapport au manchon est sensiblement la même.

Dans ce mode de réalisation, des connexions telles que la connexion $c_3$ sur la figure 10, relient l'extrémité d'une couche telle que $C_{n-1}$ à l'extrémité de la couche suivante $C_n$ située de l'autre côté du manchon 2.

Ainsi sur la figure 10, la connexion $c_3$ relie l'extrémité droite de la couche $C_{n-1}$ à l'extrémité gauche de la couche $C_n$.

Du fait de leur grande dimension, ces connexions introduisent plus de parasites que les connexions réalisées pour les modes de réalisation des figures 5 à 8.

Dans les solénoïdes selon l'invention, on utilise généralement des manchons en verre époxy. Du fait de leur fabrication, ces manchons ont une surface externe assez irrégulière et souvent décentrée par rapport à l'axe du tube. Par contre leur surface interne est parfaitement centrée par rapport à cet axe. Selon l'invention, on utilise des manchons portant une gravure hélicoïdale sur leur surface externe. Il suffit de réaliser cette gravure en se basant sur la paroi intérieure du manchon pour supprimer les inconvénients dus aux défauts de la surface externe des manchons. Il faut signaler que dans les solénoïdes selon l'art antérieur si l'on utilise ces manchons en verre époxy, il faut soit accepter les inconvénients dus aux défauts des manchons, soit modifier leur surface externe ce qui est une opération plus délicate à réaliser que la gravure du fourreau.

Pour que les spires des hélices des diverses couches aient par rapport au manchon, sensiblement la même inclinaison ou une inclinaison sensiblement contraire, on augmente légèrement le pas des dernières couches de chaque manchon.

Les solénoïdes selon l'invention présentent l'avantage d'être de fabrication plus facile que les solénoïdes connus, en particulier parce que le fil n'a plus à être guidé à la main que pour les premières spires de chaque couche après quoi il se place tout seul.

Dans les solénoïdes selon l'invention, la répartition des spires des diverses couches est quasiment parfaite et les spires sont donc sensiblement perpendiculaires à l'axe du tube. De ce fait, on a noté une amélioration des caractéristiques des tubes de prise de vue auxquels ces solénoïdes sont associés.

En particulier, on a noté :

la suppression du « décadrage » et de l'erreur d'orthogonalité ;

la suppression des parasites dus au retour rapide du faisceau commandé par les bobines de déflexion.

On a aussi noté que le taux de modulation varie peu d'un solénoïde à l'autre.

D'autre part, l'homogénéité de résolution du tube est améliorée.

D'une façon plus générale, les solénoïdes de focalisation selon l'invention présentent des caractéristiques reproductibles. Ceci est un avantage important car ces solénoïdes sont souvent utilisés dans des tubes de prise de vue en couleurs où l'on a besoin de trois solénoïdes de focalisation ayant des caractéristiques voisines.

La description précédente a été faite en considérant le cas des tubes de prise de vue, mais le solénoïde selon l'invention peut être utilisé dans d'autres domaines tels que les microscopes électroniques ou les tubes électroniques hyperfréquences où les exigences de concentration du faisceau sont particulièrement rigoureuses.

L'invention peut aussi être utilisée pour la fabrication de transformateurs ou de moteurs.

**Revendications**

1. Solénoïde de focalisation constitué d'un fil isolé (1) enroulé en forme d'hélice autour d'un manchon cylindrique isolant (2), les spires de l'hélice étant jointives et le solénoïde comportant plusieurs couches de fil superposées ayant un même sens d'enroulement autour du manchon, caractérisé en ce que :

il comporte plusieurs manchons coaxiaux (2, 3) portant chacun une gravure hélicoïdale dans laquelle sont logées les spires d'une première couche (C1) de fil (1) ;

chaque manchon présente une gravure hélicoïdale de sens contraire de celle du précédent ;

pour chacune des couches de fil enroulées en hélice autour d'un même manchon et faisant suite à la première couche, les spires de l'hélice s'engagent dans la rainure hélicoïdale que définissent les spires de la couche précédente ;

le fil est coupé après chaque couche, et

des connexions ($c_1$, $c_2$) relient les extrémités d'une couche ($C_n$) aux extrémités, situées du même côté des manchons (2, 3), de deux autres couches ($C_{n-1}$, $C_{n+1}$) réalisées autour d'un autre manchon et non enroulées dans le même sens que ladite couche ($C_n''$).

2. Solénoïde selon la revendication 1, caractérisé en ce qu'il comporte deux manchons (2, 3) portant chacun la moitié des couches ($C_d$, $C_f$).

3. Solénoïde de focalisation constitué d'un fil isolé (1) enroulé en forme d'hélice autour d'un manchon cylindrique isolant (2), les spires de l'hélice étant jointives et le solénoïde comportant plusieurs couches de fil superposées ayant un même sens d'enroulement autour du manchon, caractérisé en ce que :

ledit manchon porte une gravure hélicoïdale dans laquelle sont logées les spires de la première couche ($C_1$) ;

la première couche ($C_1$), dont les spires sont logées dans la gravure hélicoïdale dudit manchon est suivie d'autres couches enroulées en hélices autour du manchon (2) et dont les spires s'engagent dans la rainure hélicoïdale que définissent les spires de la couche précédente ;

cette première série de couches est suivie d'autres séries de couches ;

pour chaque série de couches, le sens d'enroulement est contraire à celui de la série précédente ;

pour chacune des couches de fil appartenant à une même série et faisant suite à la première couche, les spires de l'hélice s'engagent dans la rainure hélicoïdale que définissent les spires de la couche précédente ;

les couches des séries faisant suite à la première série sont agglomérées entre elles ;

le fil (1) est coupé après chaque couche, et

des connexions ($c_1$, $c_2$) relient les extrémités d'une couche ($C_n$) aux extrémités, situées du même côté du manchon (2), de deux autres couches ($C_{n-1}$, $C_{n+1}$) ne faisant pas partie de la même série et non enroulées dans le même sens que ladite couche ($C_n$)".

4. Solénoïde selon la revendication 3, caractérisé en ce qu'il comporte deux séries de couches ($C_d$, $C_f$).

5. Solénoïde selon l'une des revendications 3 ou 4, caractérisé en ce que les couches agglomérées des autres séries ($C_f$) sont réalisées en un fil dont le revêtement isolant a la propriété de devenir adhérent sous l'action de la chaleur.

6. Solénoïde selon l'une des revendications précédentes, caractérisé en ce que chaque connexion ($c_1$, $c_2$) est réalisée par deux morceaux de fil (1) appartenant à deux couches différentes qui sont torsadés ensemble et soudés.

7. Solénoïde selon l'une des revendications 1 à 6, caractérisé en ce que chaque manchon (2, 3) est en verre époxy et en ce que la gravure est réalisée en se basant sur la paroi intérieure du manchon.

8. Solénoïde selon l'une des revendications 1 à 7, caractérisé en ce que le pas de l'hélice gravée sur chaque manchon (2, 3) est très légèrement supérieur au diamètre du fil (1) et en ce que la profondeur de la gravure est de l'ordre de la moitié du diamètre du fil.

9. Solénoïde selon la revendication 8, caractérisé en ce que le fil (1) a un diamètre de 25/100$^e$ et en ce que le pas de l'hélice gravée sur chaque manchon est de 26/100$^e$ et la profondeur de la gravure est de 1/10$^e$.

10. Application d'un solénoïde de focalisation selon l'une des revendications 1 à 9 à un tube de prise de vue, et notamment à un tube de prise de vue en couleurs.

11. Application d'un solénoïde de focalisation selon l'une des revendications 1 à 9, à un tube électronique hyperfréquences.

12. Application d'un solénoïde de focalisation selon l'une des revendications 1 à 9, à un microscope électronique.

13. Procédé de fabrication d'un solénoïde selon l'une des revendications 3 à 5, caractérisé en ce qu'il comprend les étapes suivantes :

on utilise un premier manchon cylindrique isolant (2) portant une gravure hélicoïdale ;

on enroule un fil (1) en hélice autour du premier manchon (2) en introduisant les spires de la première couche ($C_1$) dans la gravure du manchon, en coupant le fil après chaque couche, et en enroulant les autres couches autour du manchon en conservant la même inclinaison des spires de l'hélice par rapport au manchon de façon qu'elles s'engagent dans la rainure hélicoïdale que définissent les spires de la couche précédente ;

on utilise ensuite un deuxième manchon (3) dont le diamètre externe égale le diamètre externe du premier manchon recouvert de ses couches de fil ($C_d$), ce deuxième manchon étant gravé en sens contraire au premier ;

on enroule le fil autour de ce deuxième manchon comme on l'a fait autour du premier en · utilisant un fil dont la gaine a la propriété de devenir adhérente sous l'effet de la chaleur ;

on agglomère entre elles les couches de fils ($C_f$) recouvrant le deuxième manchon, en chauffant le fil ;

on enlève le deuxième manchon ;

on ajuste cette deuxième série de couches autour de la première série ;

et ainsi de suite, on réalise plusieurs séries de couches ;

on réalise les connexions ($c_1$, $c_2$) entre les couches.

**Claims**

1. Focussing solenoid constituted of an insulated wire (1) helically wound about an insulating cylindrical sleeve (2), the turns of the helix being in joining relationship and the solenoid comprising a plurality of superimposed layers of wire having the same winding sense about the sleeve, characterized in that :

it comprises a plurality of coaxial sleeves (2, 3) each carrying a helical engraving wherein the turns of a first layer (C1) of wire (1) are accommodated ;

each sleeve has a helical engraving of contrary sense to that of the preceding one ;

for each of the layers of wire helical wound about the same sleeve and following the first layer the turns of the helix engage in the helical groove defined by the turns of the preceding layer ;

the wire is cut after each layer, and

connections ($c_1$, $c_2$) connect the ends of one layer ($C_n$) to the ends of the two other layers ($C_{n-1}$, $C_{n+1}$) lying on the same side of the sleeves (2, 3) and formed about another sleeve, but not being wound in the same sense as said

layer ($C_n$).

2. Solenoid according to claim 1, characterized in that it comprises two sleeves (2, 3) each carrying half of the layers ($C_d$, $C_f$).

3. Focussing solenoid constituted by an insulated wire (1) helically wound about a cylindrical insulating sleeve (2), the turns of the helix being in joining relationship and the solenoid comprising a plurality of superimposed layers of wire having the same winding sense about the sleeve, characterized in that :

said sleeve carries a helical engraving wherein the turns of the first layer ($C_1$) are accommodated ;

the first layer ($C_1$) the turns of which are accommodated in the helical engraving of said sleeve is followed by further layers helically wound about the sleeve and the turns of which engage into the helical groove defined by the turns of the preceding layer ;

this first set of layers being followed by further sets of layers ;

for each set of layers the winding sense is contrary to that of the preceding set ;

for each layer of wire belonging to the same set and following the first layer the turns of the helix engage into the helical groove defined by the turns of the preceding layer ;

the layers of sets following the first set are agglomerated with each other ;

the wire (1) is cut after each layer, and

connections ($c_1$ $c_2$) connect the ends of one layer ($C_n$) to the ends of two further layers ($C_{n-1}$, $C_{n+1}$) lying on the same side of the sleeve (2) and not belonging to the same set and not wound in the same sense as said layer ($C_n$).

4. Solenoid according to claim 3, characterized in that it comprises two sets of layers ($C_d$, $C_f$).

5. Solenoid according to any of claims 3 or 4, characterized in that the agglomerated layers of the other sets ($C_f$) are made of a wire the insulating envelope of which has the property of becoming adhesive by the action of heat.

6. Solenoid according to any of the preceding claims, characterized in that each connection ($c_1$, $c_2$) is formed by two sections of wire (1) belonging to two different layers and which are twisted and soldered.

7. Solenoid according to any of claims 1 to 6, characterized in that each sleeve (2, 3) is of epoxy glass and in that the engraving is made on the basis of the inner wall of the sleeve.

8. Solenoid according to any of claims 1 to 7, characterized in that the pitch of the helix engraved on each sleeve (2, 3) is very slightly greater than the diameter of the wire (1) and in that the depth of the engraving is of the order of half the diameter of the wire.

9. Solenoid according to claim 8, characterized in that the wire (1) has a diameter of 25/100 and in that the pitch of the helix engraved on each sleeve is of 26/100 and the depth of the engraving is of 1/10.

10. Application of a focussing solenoid according to any of claims 1 to 9 to a picture pick-up tube, in particular to a colour picture pick-up tube.

11. Application of a focussing solenoid according to any of claims 1 to 9 to an electronic hyperfrequency tube.

12. Application of a focussing solenoid according to any of claims 1 to 9 to an electronic microscope.

13. Method of producing a solenoid according to any of claims 3 to 5, characterized in that it comprises the following steps :

a first cylindrical insulating sleeve (2) is used which carries a helical engraving ;

a wire (1) is helically wound about the first sleeve (2), the turns of the first layer ($C_1$) being introduced into the engraving of the sleeve, the wire being cut after each layer, and the further layers being wound about the sleeve, the same inclination of the helix turns with respect to the sleeve being maintained, in such a manner that they engage into the helical groove defined by the turns of the preceding layer ;

a second sleeve (3) is subsequently used the outer diameter of which is equal to the outer diameter of the first sleeve covered with its layers of wire ($C_d$), this second sleeve being engraved in a sense contrary to the first ;

the wire is wound about this second sleeve in the manner this was done with the first, a wire being used the envelope of which has the property of becoming adhesive by the action of heat ;

the layers of wire ($C_f$) covering the second sleeve are agglomerated with each other by heating the wire ;

the second sleeve is removed ;

this second set of layers is adjusted about the first set ;

in the same manner a plurality of sets of layers is produced ;

the connections ($c_1$, $c_2$) between the layers are made.


**Patentansprüche**

1. Fokussierspule, gebildet aus einem isolierten Draht (1), der schraubenförmig um eine zylindrische isolierende Hülse (2) aufgewickelt ist, wobei die Windungen der Schraube aneinander liegen und die Spule mehrere Lagen Draht übereinander aufweist, welche denselben Wicklungssinn um die Hülse herum aufweisen, dadurch gekennzeichnet, daß :

sie mehrere koaxiale Hülsen (2, 3) umfaßt, die jeweils eine schraubenförmige Gravierung aufweisen, in welcher die Windungen einer ersten Lage (C1) des Drahtes (1) aufgenommen sind ;

jede Hülse eine schraubenförmige Gravierung mit entgegengesetzter Steigung wie die vorausgehende aufweist ;

für jede der schraubenförmig auf dieselbe Hülse aufgewickelten Drahtlagen, welche auf die erste Lage folgen, dringen die Windungen der Schraube in die schraubenförmige Rille ein, welche die Windungen der vorausgehenden Schicht begrenzen ;

der Draht ist nach jeder Schicht abgeschnitten, und

Verbindungen ($c_1$, $c_2$) verbinden die Enden einer Lage ($C_n$) mit den auf derselben Seite der Hülsen (2, 3) liegenden Enden der zwei anderen Lagen ($C_{n-1}$, $C_{n+1}$), welche auf einer anderen Hülse aufgebracht sind und nicht mit derselben Steigung wie die genannte Lage ($C_n$) gewickelt sind.

2. Spule nach Anspruch 1, dadurch gekennzeichnet, daß sie zwei Hülsen (2, 3) umfaßt, die jeweils die Hälfte der Lagen ($C_d$, $C_f$) tragen.

3. Fokussierspule, die aus einem isolierten Draht (1) gebildet ist, welcher schraubenförmig auf einer zylindrischen isolierenden Hülse (2) aufgewickelt ist, wobei die Windungen der Schraube aneinandergefügt sind und die Spule mehrere Lagen von Draht übereinander aufweist, die denselben Wicklungssinn auf der Hülse aufweisen, dadurch gekennzeichnet, daß :

die genannte Hülse eine schraubenförmige Gravierung aufweist, worin die Windungen der ersten Lage ($C_1$) aufgenommen sind ;

die erste Schicht ($C_1$), deren Windungen in der schraubenförmigen Gravierung der genannten Hülse aufgenommen sind, von weiteren Schichten gefolgt wird, die schraubenförmig auf der Hülse (2) aufgewickelt sind und deren Windungen in die schraubenförmige Rille eingreifen, welche die Windungen der vorausgehenden Schicht bilden ;

auf diese erste Reihe von Lagen weitere Reihen von Lagen folgen ;

für jede Reihe von Lagen der Wicklungssinn entgegengesetzt zu dem der vorausgehenden Reihe ist ;

für jede Drahtlage, welche zu derselben Reihe gehört und die auf die erste Lage folgt, greifen die Windungen der Schraube in die schraubenförmige Rille ein, welche die Windungen der vorausgehenden Lage bilden ;

die Lagen der Reihen, welche auf die erste Reihe folgen, bilden ein Agglomerat miteinander ;

der Draht (1) ist nach jeder Lage abgeschnitten und

Verbindungen ($c_1$, $c_2$) verbinden die Enden einer Lage ($C_n$) mit den auf derselben Seite der Hülse (2) liegenden Enden von zwei anderen Lagen ($C_{n-1}$, $C_{n+1}$), welche nicht zu der ersten Reihe gehören und die nicht im selben Sinn aufgewickelt sind wie die genannte Schicht ($C_n$).

4. Spule nach Anspruch 3, dadurch gekennzeichnet, daß sie zwei Reihen von Lagen ($C_d$, $C_f$) umfaßt.

5. Spule nach Anspruch 3 oder 4, dadurch gekennzeichnet, daß die ein Agglomerat bildenden Lagen der anderen Reihen ($C_f$) aus einem Draht gebildet sind, dessen Isolierbeschichtung die Eigenschaft aufweist, daß sie unter der Einwirkung von Wärme anhaftend wird.

6. Spule nach einem der vorstehenden Ansprüche, dadurch gekennzeichnet, daß jede Verbindung ($c_1$, $c_2$) durch zwei Drahtstücke (1) gebildet ist, die zu zwei verschiedenen Lagen gehören und miteinander verdrillt und verlötet sind.

7. Spule nach einem der Ansprüche 1 bis 6, dadurch gekennzeichnet, daß jede Hülse (2, 3) aus einem Epoxyglas besteht und daß die Gravierung auf der Grundlage der Innenwand der Hülse ausgeführt wird.

8. Spule nach einem der Ansprüche 1 bis 7, dadurch gekennzeichnet, daß die Steigung der an jeder Hülse (2, 3) gravierten Schraube sehr geringfügig größer als der Durchmesser des Drahtes (1) ist und daß die Tiefe der Rille die Größenordnung der Hälfte des Drahtdurchmessers aufweist.

9. Spule nach Anspruch 8, dadurch gekennzeichnet, daß der Draht (1) einen Durchmesser von 25/100 aufweist und daß die Steigung der auf jeder Hülse gravierten Schraube 26/100 beträgt und die Tiefe der Gravierung 1/10 beträgt.

10. Anwendung einer Fokussierspule nach einem der Ansprüche 1 bis 9 auf eine Bildaufnahmeröhre, insbesondere eine Farb-Bildaufnahmeröhre.

11. Anwendung einer Fokussierspule nach einem der Ansprüche 1 bis 9 auf eine Mikrowellen-Elektronenröhre.

12. Anwendung einer Fokussierspule nach einem der Ansprüche 1 bis 9 auf ein Elektronenmikroskop.

13. Verfahren zur Herstellung einer Spule nach einem der Ansprüche 3 bis 5, dadurch gekennzeichnet, daß es die folgenden Schritte umfaßt :

eine erste zylindrische isolierende Hülse (2) wird verwendet, die eine schraubenförmige Gravierung trägt ;

ein Draht (1) wird schraubenförmig auf der ersten Hülse (2) aufgewickelt, indem die Windungen der ersten Lage ($C_1$) in die Gravierung der Hülse eingeführt werden, wobei der Draht nach jeder Lage abgeschnitten wird, und indem die weiteren Lagen auf der Hülse aufgewickelt werden, indem dieselbe Neigung der Schraubenwindungen bezüglich der Hülse beibehalten wird, so daß sie in die schraubenförmige Rille eingreifen, welche die Windungen der vorausgehenden Lage bilden ;

anschließend wird eine zweite Hülse (3) verwendet, deren Außendurchmesser gleich dem Außendurchmesser der ersten Hülse ist, die mit ihren Drahtlagen ($C_d$) bedeckt ist, wobei diese zweite Hülse in entgegengesetztem Sinne zur ersten graviert ist ;

der Draht wird auf dieser zweiten Hülse ebenso wie auf der ersten aufgewickelt, wobei ein Draht verwendet wird, dessen Umhüllung die Eigenschaft besitzt, daß sie unter der Einwirkung von Wärme anhaftend wird ;

aus den Drahtlagen ($C_f$), welche die zweite Hülse bedecken, wird durch Erwärmung des Drahtes ein Agglomerat gebildet ;

die zweite Hülse wird entfernt ;

diese zweite Reihe von Lagen wird um die erste Reihe herum justiert ;

in gleicher Weise werden mehrere Reihen von Lagen gebildet ;

die Verbindungen ($c_1$, $c_2$) zwischen den Lagen

werden hergestellt.

# FIG_ 1

# FIG_ 2

# FIG_ 3

# FIG_4

(a)

(b)

# FIG_5

# FIG_6

# FIG_7

Cd

Cf

3

0

2

0'

# FIG_8

4

5

6

3

# FIG_9

# FIG_10